# EUROPEAN PATENT SPECIFICATION

(11) **EP 4 584 887 B1**
(45) Date of publication and mention of the grant of the patent: **17.06.2026**
(21) Application number: 23786885.6
(22) Date of filing: 18.09.2023
(51) Int. Cl.: H04B 1/04, H03F 3/45

(54) **WIDE BAND POWER DETECTOR WITH HIGH DYNAMIC RANGE**
BREITBANDIGER LEISTUNGSDETEKTOR MIT HOHEM DYNAMIKBEREICH
DÉTECTEUR DE PUISSANCE À LARGE BANDE À PLAGE DYNAMIQUE ÉLEVÉE

(30) Priority: 19.09.2022 US 202263408019 P
(43) Date of publication of application: 16.07.2025
(73) Proprietor: ViaSat, Inc., Carlsbad, CA 92009 (US)
(72) Inventor: JALALEDDINE, Sateh, Carlsbad, California 92009 (US)
(74) Representative: Swindell & Pearson Limited
(86) International application number: PCT/US2023/033040
(87) International publication number: WO 2024/064081

(56) References cited:
- US-A1- 2005 135 520
- US-A1- 2009 267 846
- US-A1- 2011 193 550
- US-B2- 7 317 902

## Description

### BACKGROUND

The following relates generally to communications, including wide band power detector with high dynamic range.

In some examples, a device may receive or transmit radio frequency (RF) signals via one or more antennas. The device may include amplifiers to apply gain to the RF signals within transmission or reception chains. For example, transmission of an RF signal may include amplification of the RF signal prior to sending the amplified RF signal to the one or more antennas. The device may have a desired output RF signal power, which may depend on the one or more antennas, receiver characteristics such as the distance to the receiver, or environmental conditions. Techniques that enable the device to determine the RF signal power more accurately or with reduced latency may reduce a likelihood that the applied gain causes the RF signal to have an undesired value.

US 2005/0135520 A1 discloses a multi-branch radio frequency amplifying apparatus and method.

US 7,317,902 B2 discloses a successive log pad power detector and method.

### SUMMARY

The invention is defined in the appended claims. The described techniques relate to improved methods, systems, devices, and apparatuses that support a wide band power detector with high dynamic range. For example, the described techniques provide for a device to output a voltage indicating a power of an RF signal with reduced latency, a wider dynamic range, an increased linearity, or any combination thereof.

The described techniques include generating, by a set of multiple passive attenuators coupled in parallel between a first port and a set of multiple second ports and based on a radio frequency (RF) signal input to the first port, a respective set of multiple attenuated RF signals on the set of multiple second ports, where each of the set of multiple passive attenuators has a different attenuation and outputting, by a set of multiple rectifiers having respective input ports coupled with respective second ports of the set of multiple second ports, respective currents at respective output ports that are dependent on respective powers of respective attenuated RF signals on the respective second ports, and where the respective output ports of the set of multiple rectifiers are coupled together.

### BRIEF DESCRIPTION OF THE DRAWINGS

FIG. 1 shows an example of a wide band power detector with high dynamic range in accordance with examples described herein.
FIG. 2 shows an example of a wide band power detector with high dynamic range in accordance with examples described herein.
FIG. 3 shows an example of a power detection relationship that supports a wide band power detector with high dynamic range in accordance with aspects of the present disclosure.
FIG. 4 shows an example of a rectifier circuit that supports a wide band power detector with high dynamic range in accordance with aspects of the present disclosure.
FIGs. 5A, 5B, and 5C show examples of passive attenuation schemes that support a wide band power detector with high dynamic range in accordance with aspects of the present disclosure.
FIG. 6 shows a flowchart illustrating methods that support a wide band power detector with high dynamic range in accordance with aspects of the present disclosure.

### DETAILED DESCRIPTION

A device may receive or transmit radio frequency (RF) signals via one or more antennas. The device may include amplifiers to apply gain to the RF signals within transmission or reception chains. For example, transmission of an RF signal may include amplification of the RF signal prior to sending the amplified RF signal to the one or more antennas. The device may have a desired output RF signal power, which may depend on the one or more antennas, receiver characteristics such as the distance to the receiver, or environmental conditions. In order to determine the gain, the device may include an RF power detector that produces a voltage corresponding to a value of a power of the RF signal. The device may use the value of the power of the RF signal in order to adjust the gain.

Reducing a latency between an RF signal and an adjusting of the gain may enable the device to more quickly adapt to channel conditions and to reduce a likelihood that an applied gain results in an undesired signal power. Additionally, as a relationship between a power of the RF signal (e.g., in decibels (dB)) and a voltage output by an RF power detector approaches linearity, the power gain may be adjusted more accurately and/or with less complexity.

The techniques and circuitry described herein may enable reduced latency between applying an RF signal and the RF power detector outputting a corresponding voltage and/or may enable increased linearity between a power of the RF signal and the voltage output by the RF power detector. For instance, the RF power detector of the device may include multiple rectifiers coupled in parallel between an input port for the RF signal and an output port for the voltage indicating the power of the RF signal. Each of a subset of the multiple rectifiers may be coupled with a respective one or more passive attenuators (e.g., resistors, capacitors), where the respective one or more passive attenuators are configured to provide a different amount of attenuation for each of the subset of the multiple rectifiers. In some examples, using passive attenuators may be advantageous over active attenuators (e.g., attenuators composed of actively powered components, such as gain cells or operational amplifiers), as the passive attenuators may incur less delay or consume less energy relative to the active attenuators.

Each rectifier of the set of rectifiers may have an order defined in terms of a stage, where each stage may include a respective rectifier and its respective one or more passive attenuators, if present. Generally, each stage in the order may be associated with a progressively higher amount of attenuation (e.g., due to the respective one or more passive attenuators providing more attenuation). Thus, if each rectifier of the multiple rectifiers is configured such that the rectifier is activated for a same signal power provided to a respective input of the rectifier, each of the multiple rectifiers may still activate for different power values associated with the RF signal due to the respective one or more attenuators providing different amounts of attenuation. For instance, if the set of rectifiers has a first rectifier in a first stage with no attenuators, a second rectifier in a second stage with a first set of attenuators, and a third rectifier in a third stage with a second set of attenuators, where the second set of attenuators provide more attenuation than the first set of attenuators, then the first rectifier may be activated for a lower power value of the RF signal than the second rectifier, and the second rectifier may be activated for a lower power value of the RF signal than the third rectifier. Similarly, a current provided by a rectifier in an earlier stage may saturate for a lower power value of the RF signal than a current provided by a rectifier in a later stage. For instance, the first rectifier may have its current saturate at a lower power value of the RF signal than the second rectifier, and the second rectifier may have its current saturate at a lower power value of the RF signal than the third rectifier.

Generally, the respective one or more passive attenuators for each stage may be configured such that a rectifier for one stage has its current reach saturation at a same power value that another rectifier has current exhibiting linear behavior. For instance, the attenuation may be configured according to a power law such that an increase in power (e.g., doubling, quadrupling) causes one rectifier to saturate while the next is in the linear region. In this manner, each stage may have a respective separate range of power values between which the respective rectifier begins to pull current (e.g., to be activated) and which the current output by the rectifier becomes saturated. The current output from a respective rectifier for its respective range of power values may exhibit approximately linear behavior (e.g., with reference to a power of the RF signal in dB) whereas the current output from the remaining rectifiers may exhibit approximately constant behavior for that range of power values. For instance, for the respective range of power values over which the second rectifier exhibits approximately linear behavior, the first rectifier may output an approximately constant, saturated current and the third rectifier may not be pulling current.

Due to the approximately linear behavior of each rectifier over the respective range of power values for their stage and the respective one or more passive attenuators being configured such that a rectifier for one stage has its current reach saturation while another rectifier has current exhibiting linear behavior, the voltage produced at the output port when the currents are summed together may also exhibit approximately linear behavior. Thus, the relationship between the power of the RF signal and the voltage output at the output port may be approximately linear.

Having the multiple rectifiers coupled in parallel may enable reduced latency between input of an RF signal and the RF power detector outputting the corresponding voltage (e.g., as compared to coupling the multiple rectifiers in series). Additionally, the multiple rectifiers being coupled in parallel may enable a higher dynamic range for the RF power detector (e.g., adding additional rectifiers may enable increased dynamic range) and may increase a linearity associated with the output voltage over the dynamic range.

Aspects of the disclosure are initially described in the context of power detectors. Additional aspects of the disclosure are described in the context of a power detection relationship, a rectifier circuit, and passive attenuation schemes. Aspects of the disclosure are further illustrated by and described with reference to apparatus diagrams, system diagrams, block diagrams, and flowcharts that relate to wide band power detector with high dynamic range.

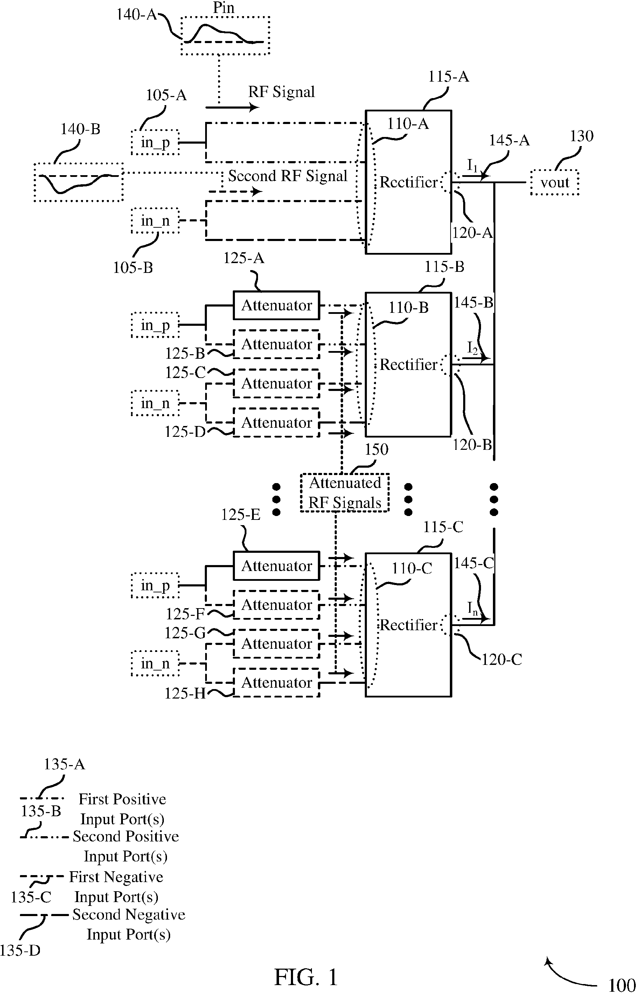

**FIG.** 1 shows an example of a wide band power detector 100 with high dynamic range in accordance with examples described herein.

Wide band power detector 100 may include a set of rectifiers including rectifiers 115-a, 115-b, and 115-c. Each rectifier may include a respective set of input ports. For instance, rectifier 115-a may include set of input ports 110-a, rectifier 115-b may include a set of input ports 110-b, and rectifier 115-c may include a set of input ports 110-c. In some examples, one or more of the sets of input ports may be coupled with attenuators. For instance, a first input port (e.g., a respective first positive input port 135-a) of the set of input ports 110-b may be coupled with attenuator 125-a, a second input port (e.g., a respective second positive input port 135-b) of the set of input ports 110-b may be coupled with attenuator 125-b, a third input port of the set of input ports 110-b (e.g., a respective first negative input port 135-c) may be coupled with attenuator 125-c; and a fourth port of the set of input ports 110-b (e.g., a respective second negative input port 135-d) may be coupled with attenuator 125-d. Similarly, a first input port of the set of input ports 110-c (e.g., a respective first positive input port 135-a) may be coupled with attenuator 125-e, a second input port of the set of input ports 110-c (e.g., a respective second positive input port 135-b) may be coupled with attenuator 125-f; a third input port of the set of input ports 110-c (e.g., a respective first negative input port 135-c) may be coupled with attenuator 125-g; and a fourth input port of the set of input ports 110-c (e.g., a respective second negative input port 135-d) may be coupled with attenuator 125-h. Additionally, each of attenuators 125-a, 125-b, 125-f, and 125-g may be coupled with positive port 105-a and each of attenuators 125-c, 125-d, 125-g, and 125-h may be coupled with negative port 105-b. The set of input ports 110-a for rectifier 115-a may be coupled directly (e.g., without attenuators) to positive port 105-a and negative port 105-b. For instance, a first port (e.g., a respective first positive input port 135-a) and a second port (e.g., a respective second positive input port 135-b) of the set of input ports 110-a may be coupled with positive port 105-a and a third port (e.g., a respective first negative input port 135-c) and a fourth port (e.g., a respective second negative input port 135-d) of the set of input ports 110-a may be coupled with negative port 105-b. Rectifiers 115-a, 115-b, and 115-c may each have a respective output port. For instance, rectifier 115-a may have output port 120-a, rectifier 115-b may have output port 120-b, and rectifier 115-c may have output port 120-c, where output ports 120-a, 120-b, and 120-c may be coupled together.

Each of attenuators 125-a through 125-h may be passive attenuators. For instance, each of attenuators 125-a through 125-h may be an example of a resistor or may be an example of one or more capacitors. Each of attenuators 125-a through 125-h may also be understood to include a parasitic capacitance of a respective transistor with which they are coupled (e.g., a respective transistor of rectifier 115-b for attenuators 125-a through 125-d and a respective transistor of rectifier 115-c for attenuators 125-e through 125-g). In some cases, each attenuator 125 may include a single passive component (e.g., resistor, capacitor) that is coupled between one of the ports 105 and an input port of one of the rectifiers 115.

The first input port (e.g., positive port 105-a) may be configured to provide an RF signal 140-a to the positive input ports of the set of rectifiers (e.g., directly for rectifier 115-a or via respective attenuators for rectifier 115-b and 115-c). The second input port (e.g., negative port 105-b) may be configured to provide a second RF signal 140-b (e.g., a complementary signal of RF signal 140-a) to the negative input ports of the set of rectifiers. Attenuators 125-a, 125-b, 125-e and 125-f may be configured to attenuate the RF signal 140-a prior to the RF signal 140-a being received at the input ports of rectifiers 115-b and 115-c. Attenuators 125-c, 125-d, 125-g, and 125-h may be configured to attenuate the second RF signal 140-b prior to the second RF signal 140-b being received at the input ports of rectifiers 115-b and 115-c. Attenuators 125-a through 125-h performing the attenuation may generate a set of attenuated RF signals 150. In some examples, each attenuator for a given rectifier may provide a same amount of attenuation (e.g., may have a same resistance or a same capacitance as each other attenuator for that rectifier). For instance, attenuators 125-a through 125-d may provide a same amount of attenuation and attenuators 125-e through 125-h may provide a same amount of attenuation. Additionally, the attenuators for a first rectifier may have a different attenuation as compared to the attenuators for a second rectifier (e.g., for each other rectifier). For instance, attenuators 125-a through 125-d may provide a different attenuation as compared to attenuators 125-e through 125-h (e.g., may have different resistances or different capacitances relative to attenuators 125-e through 125-h).

In some examples, rectifiers 115-b and 115-c may be included in a set of rectifiers each coupled with a respective set of attenuators and a respective output port coupled with the other output ports of the set of rectifiers. Additionally, the set of rectifiers may have a predefined ordering defined in terms of a stage. For instance, if rectifier 115-b is a Stage 2 rectifier and rectifier 115-c is a Stage 3 rectifier, then rectifier 115-b may occur earlier in the ordering as compared to rectifier 115-c. Each stage later in the ordering may have attenuators that provide more attenuation as compared to attenuators associated with stages earlier in the ordering. For instance, attenuators 125-e through 125-h may provide more attenuation than attenuators 125-a through 125-d if rectifier 115-b is a Stage 2 rectifier and rectifier 115-c is a Stage 3 rectifier. In a first example, attenuators coupled with a Stage 2 rectifier may provide 3 dB of attenuation, attenuators coupled with a Stage 3 rectifier may provide 6 dB of attenuation, attenuators coupled with a Stage 4 rectifier may provide 9 dB of attenuation, attenuators coupled with a Stage 5 rectifier may provide '1 dB of attenuation, and so on. In a second example, attenuators coupled with a Stage 2 rectifier may provide 4 dB of attenuation, attenuators coupled with a Stage 3 rectifier may provide 8 dB of attenuation, attenuators coupled with a Stage 4 rectifier may provide 12 dB of attenuation, and so on. Other values of attenuation may be possible without deviating from the scope of the present disclosure. In some examples, as rectifier 115-a may be coupled directly with positive port 105-a and negative port 105-b (e.g., as rectifier 115-a may not be coupled with a respective set of attenuators), rectifier 115-a may be referred to a Stage 1 rectifier and may, thus, be associated with less attenuation than each other rectifier within the set of rectifiers (e.g., rectifiers 115-b and 115-c).

Coupled to attenuators 125 as illustrated in FIG. 1, rectifiers 115-a through 115-c may be configured to output respective currents at respective output ports that are dependent on respective powers of the signals (e.g., the respective attenuated RF signals) received at their respective input ports. For instance, rectifier 115-a may output a current 145-a dependent on a power of RF signal 140-a and/or second RF signal 140-b; rectifier 115-b may output a current 145-b dependent on a power of RF signal 140-a and/or second RF signal 140-b attenuated by one or more of attenuators 125-a through 125-d; and rectifier 115-c may output a current 145-c dependent on a power of RF signal 140-a and/or second RF signal 140-b attenuated by one or more of attenuators 125-e through 125-h.

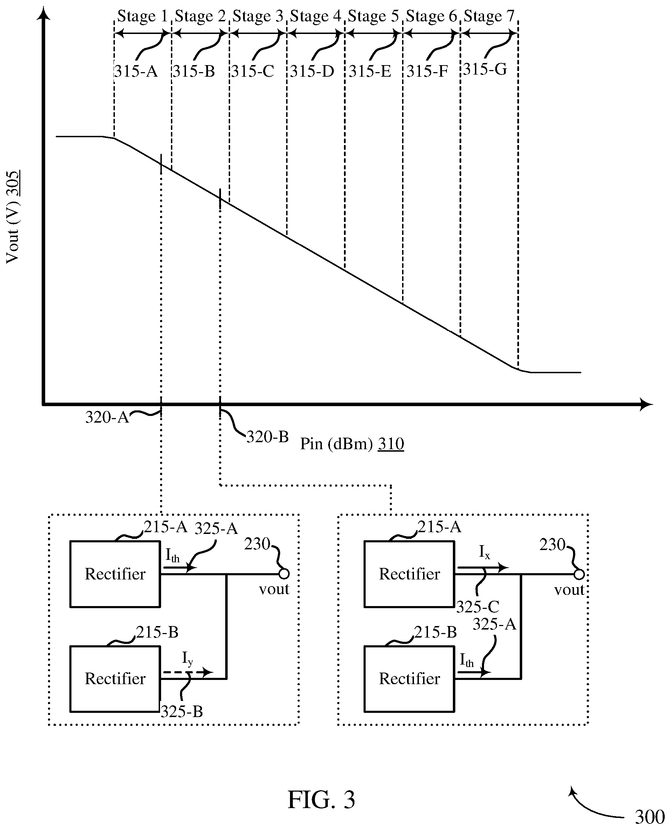

The current output by each rectifier may have approximately linear behavior (e.g., linear in dB) over its respective range of power values. The currents output by the rectifiers (e.g., 145-a through 145-c) may be summed together, which may affect an output voltage 130 that indicates a power of RF signal 140-a. For instance, the output voltage 130 may exhibit approximately linear behavior (e.g., linear in dB) due to each set of attenuators being configured such that a rectifier for one stage has its current reach saturation while another rectifier has current exhibiting linear behavior. Additional examples of rectifiers 115-a through 115-c outputting a current may be described herein, for instance, with reference to FIG. 3.

In some examples, each of rectifiers 115-a through 115-c may be single-sided and may have only one input port. For instance, the set of input ports 110-a may only include one input port coupled directly with positive port 105-a. Additionally, the set of input ports 110-b may only have one input port coupled with attenuator 125-a and the set of input ports 110-c may only have one input port coupled with attenuator 125-e. In such examples, negative port 105-b and/or attenuators 125-b through 125-d and 125-f through 125-h may not be present.

In other examples, each of rectifiers 115-a through 115-c may be differential and may have two input ports. For instance, the set of input ports 110-a may include a first input port coupled directly with positive port 105-a and a second input port coupled directly with negative port 105-b. Additionally, the set of input ports 110-b may have a first input port coupled with attenuator 125-a and a second input port coupled with attenuator 125-c and the set of input ports 110-c may have a first input port coupled with attenuator 125-e and a second input port coupled with attenuator 125-g. In such examples, attenuators 125-b, 125-d, 125-f, and 125-h may not be present.

It should be noted that a quantity of the set of rectifiers may vary (e.g., to be greater than or equal to 2) without deviating from the scope of the present disclosure.

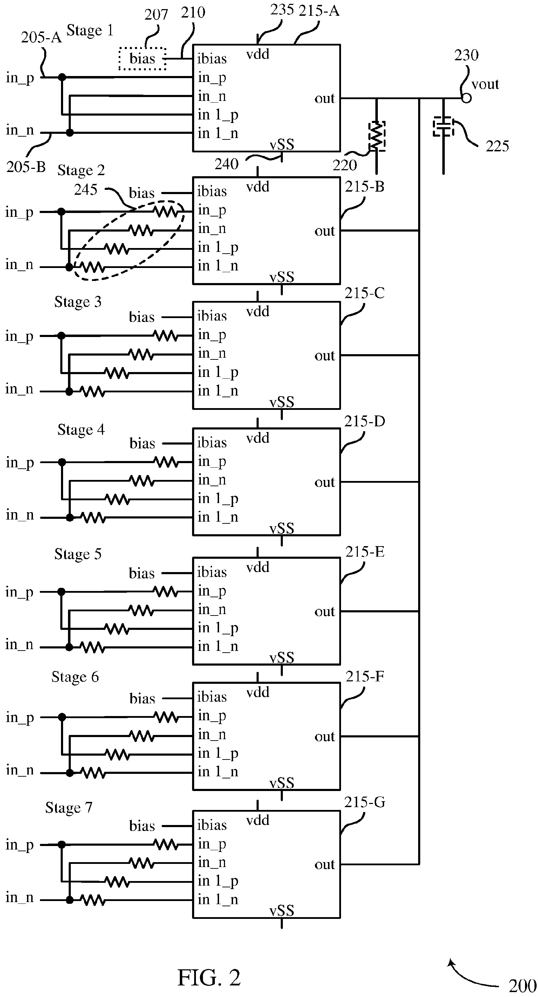

**FIG.** 2 shows an example of a wide band power detector 200 with high dynamic range in accordance with examples described herein. In some examples, wide band power detector 200 may implement one or more aspects of wide band power detector 100. For instance positive port 205-a may be an example of a positive port 105-a as described with reference to FIG. 1; negative port 205-b may be an example of a negative port 105-b as described with reference to FIG. 1; rectifier 215-a may be an example of a rectifier 115-a as described with reference to FIG. 1; rectifiers 215-b through 215-g may each be an example of rectifier 115-b or rectifier 115-c as described with reference to FIG. 1; each attenuator of the set of attenuators 245 may be an example of an attenuator 125-a through 125-h as described with reference to FIG. 1; and output voltage 230 may be an example of output voltage 130 as described with reference to FIG. 1.

Wide band power detector 200 may include a set of rectifiers (e.g., rectifiers 215-a, 215-b, 215-c, 215-d, 215-e, 215-f, and 215-g). Each rectifier of the set of rectifiers may be coupled with positive port 205-a and negative port 205-b (e.g., directly for rectifier 215-a or via a respective set of attenuators 245 for rectifiers 215-b through 215-g). Additionally, each rectifier of the set of rectifiers may be coupled with a bias port 210 (e.g., a port configured to provide a bias voltage 207 that is common to each of the set of rectifiers); a drain supply voltage line 235 (e.g., a line configured to provide *V_{dd}* to each of the set of rectifiers) and a source supply voltage line 240 (e.g., a line configured to provide *Vₛₛ* to each of the set of rectifiers). Additionally, each rectifier of the set of rectifiers may have a respective output port coupled with resistor 220 and capacitor 225, where each rectifier of the set of rectifiers may be configured to provide a current over the respective output port, which may affect a value of an output voltage 230. Each rectifier may be associated with a respective stage. For instance, rectifier 215-a may be referred to as a Stage 1 rectifier; rectifier 215-b may be referred to as a Stage 2 rectifier; rectifier 215-c may be referred to as a Stage 3 rectifier; rectifier 215-d may be referred to as a Stage 4 rectifier; rectifier 215-e may be referred to as a Stage 5 rectifier; rectifier 215-f may be referred to as a Stage 6 rectifier; and rectifier 215-g may be referred to as a Stage 7 rectifier. The resistor 220 may act as a current to voltage converter to allow the voltage to be evaluated.

Each stage of wide band power detector 200 may be fed an RF signal with power *Pᵢₙ* directly, which may allow for higher speed operation (e.g., as compared to the stages being coupled in series). The set of attenuators 245 for each rectifier (e.g., for each rectifier cell) may be different such that each rectifier contributes to a different range of input power. The collection of parallel rectifiers may be used to increase a dynamic range which the wide band power detector 200 may provide and may enable the output voltage 230 to be approximately linear with power *Pᵢₙ* for at least a range of values of power *Pᵢₙ* (e.g., and may accordingly provide piecewise logarithmic power to voltage detection through use of the parallel rectifiers). Each of rectifiers 215-b through 215-g may use RC attenuation to allow each stage to detect a corresponding input power range, where the capacitance may be provided by parasitic capacitance of transistors of rectifiers 215-b through 215-g. In some examples, a resistor of the respective set of attenuators 245 for each of rectifiers 215-b through 215-g may be replaced by one or more capacitors, which may be result in capacitor divider that achieves attenuation of the input RF signal.

**FIG.** 3 shows an example of a power detection relationship 300 that supports a wide band power detector with high dynamic range in accordance with aspects of the present disclosure. In some examples, power detection relationship 300 may be implemented by one or more components of FIGs. 1 and/or 2. For instance, output voltage 305 may be an example of an output voltage 130 as described with reference to FIG. 1 and/or an output voltage 230 as described with reference to FIG. 2. Additionally, input power 310 may be an example of a power of an RF signal (e.g., RF signal 140-a) as described with reference to FIG. 1 or an RF signal with power *Pᵢₙ* fed over positive port 205-a of FIG. 2.

Ranges of power values 315-a through 315-g may represent a range of power values of the RF signal between which a rectifier becomes active (e.g., begins pulling current) and which the current saturates. For instance, first range of power values 315-a may correspond to a range of power values between rectifier 215-a (e.g., a Stage 1 rectifier) beginning to pull current and an output current saturating; second range of power values 315-b may correspond to a range of power values between rectifier 215-b (e.g., a Stage 2 rectifier) beginning to pull current and an output current saturating; third range of power values 315-c may correspond to a range of power values between rectifier 215-c (e.g., a Stage 3 rectifier) beginning to pull current and an output current saturating; fourth range of power values 315-d may correspond to a range of power values between rectifier 215-d (e.g., a Stage 4 rectifier) beginning to pull current and an output current saturating; fifth range of power values 315-e may correspond to a range of power values between rectifier 215-e (e.g., a Stage 5 rectifier) beginning to pull current and an output current saturating; sixth range of power values 315-f may correspond to a range of power values between rectifier 215-f (e.g., a Stage 6 rectifier) beginning to pull current and an output current saturating; and seventh range of power values 315-g may correspond to a range of power values between rectifier 215-g (e.g., a Stage 7 rectifier) beginning to pull current and an output current saturating.

The current provided by a rectifier during its associated range of power values may exhibit approximately linear behavior and may be referred to as the linear range of the rectifier. For instance, within the first range of power values 315-a, the current of rectifier 215-a may progress through its linear range. Within the second range of power values 315-b, the current of rectifier 215-b may progress through its linear range while the current provided by rectifier 215-a may be saturated. Within the third range of power values 315-c, the current of rectifier 215-c may progress through its linear range while the currents provided by rectifiers 215-a and 215-b may be saturated. Within the fourth range of power values 315-d, the current of rectifier 215-d may progress through its linear range while the currents provided by rectifiers 215-a through 215-c may be saturated. Within the fifth range of power values 315-e, the current of rectifier 215-e may progress through its linear range while the currents provided by rectifiers 215-a through 215-d may be saturated. Within the sixth range of power values 315-f, the current of rectifier 215-f may progress through its linear range while the currents provided by rectifiers 215-a through 215-e may be saturated. Within the seventh range of power values 315-g, the current of rectifier 215-g may progress through its linear range while the currents provided by rectifiers 215-a through 215-f may be saturated. Above the seventh range of power values 315-g, the currents provided by rectifiers 215-a through 215-g may be saturated.

For each range of power values, the current output by the respective rectifier associated with that range of power values may have a greatest ability to vary within the range of power values (e.g., the current output by rectifier 215-a may have the greatest ability to vary within first range of power values 315-a, the current output by rectifier 215-b may have the greatest ability to vary within the second range of power values 315-b, and so on). Additionally, or alternatively, for each range of power values, the current output by the respective rectifier associated with that range of power values may vary more than a current provided by each other rectifier. For instance, the current provided by rectifier 215-a may have a greater ability to vary than that of rectifiers 215-b through 215-g within first range of power values 315-a, the current provided by rectifier 215-b may have a greater ability to vary than that of rectifiers 215-a and 215-c through 215-g within second range of power values 315-b, and so on.

The output voltage 305 varying may be caused at least in part by a summing of the currents provided by rectifiers 215-a through 215-g on resistor 220. It should be noted that the quantity of stages and corresponding ranges of power values may vary (e.g., be greater than or equal to 2) without deviating from the scope of the present disclosure. In some examples, a minimum value of the first range of power values 315-a may be -20 dB milliwatts (dBm) and a maximum value of sixth range of power values may be 11 dBm. Additionally, or alternatively, a voltage at the minimum value of the first range of power values 315-a may be between 1.3 and 1.4 volts and a voltage at a maximum value of the seventh range of power values may be between 0.1 and 0 volts.

As depicted herein, at a first power value 320-a within the first range of power values 315-a, rectifier 215-a may output a threshold current 325-a (e.g., *Iₜₕ*) while rectifier 215-b may output current 325-b (e.g., *I_{y}*), which may not satisfy the threshold current 325-a. However, at a second power values 320-b within the second range of power values 315-b, rectifier 215-b may output the threshold current 325-a while rectifier 215-a may output current 325-c (e.g., *Iₓ*) which may satisfy the threshold current 325-a.

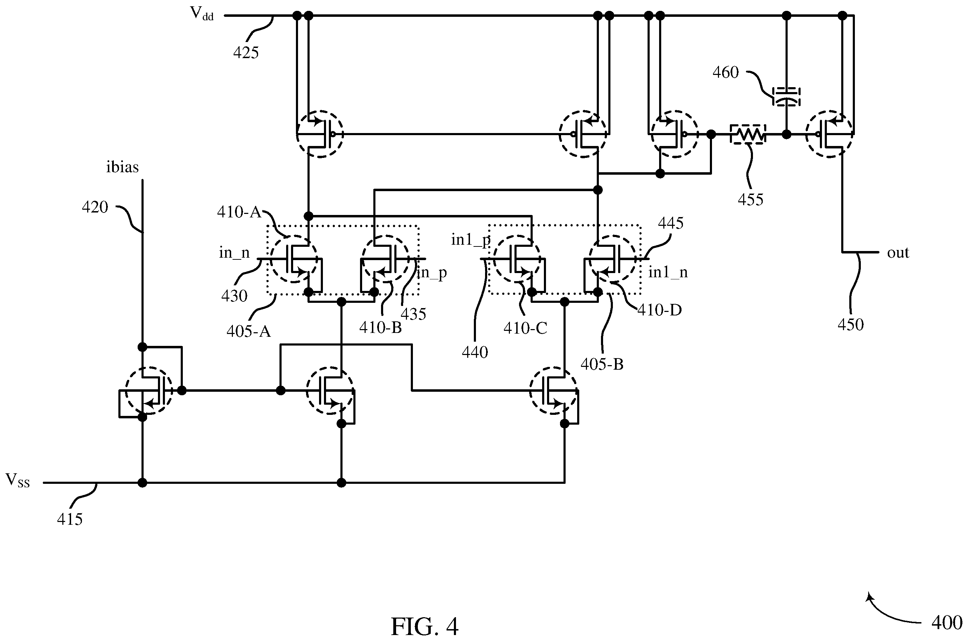

**FIG.** 4 shows an example of a rectifier circuit 400 that supports a wide band power detector with high dynamic range in accordance with aspects of the present disclosure. In some examples, rectifier circuit 400 may be an example of one or more aspects of FIGs. 1 and/or 2. For instance, rectifier circuit 400 may represent an internal view of any of rectifiers 115-a through 115-c as described with reference to FIG. 1 and/or an internal view of any of rectifiers 215-a through 215-g as described with reference to FIG. 2. In some examples, source supply voltage line 415 may be an example of a source supply voltage line 240 as described with reference to FIG. 2; bias port 420 may be an example of a bias port 210 as described with reference to FIG. 2; drain supply voltage line 425 may be an example of a drain supply voltage line 235 as described with reference to FIG. 2; negative input ports 430 and 445 may be examples of negative input ports coupled with negative port 205-b of FIG. 2; positive input ports 435 and 440 may be examples of positive input ports coupled with positive port 205-a of FIG. 2; and output port 450 may be an example of an output port of any of rectifiers 215-a through 215-g as described with reference to FIG. 2. Additionally, or alternatively, negative input port 430 may be an example of a first negative input port 135-c and/or an input port of 110-a through 110-c as described with reference to FIG. 1; positive input port 435 may be an example of a first positive input port 135-a and/or an input port of 110-a through 110-c as described with reference to FIG. 1; second positive input port 440 may be an example of a second positive input port 135-b and/or an input port of 110-a through 110-c as described with reference to FIG. 1; second negative input port 445 may be an example of a second negative input port 135-d and/or an input port of 110-a through 110-c as described with reference to FIG. 1; and output port 450 may be an example of any of output ports 120-a, 120-b, or 120-c.

First negative input port 430 may be coupled with a gate of transistor 410-a, first positive input port 435 may be coupled with a gate of transistor 410-b, second positive input port 440 may be coupled with a gate of transistor 410-c; and second negative input port 445 may be coupled with a gate of transistor 410-d. Transistors 410-a and 410-b may be included in a first rectification stage 405-a and transistors 410-c and 410-d may be included in a second rectification stage 405-b.

In some examples, rectifier circuit 400 may act as a differential rectifier in order to output a voltage at output port 450 associated with a power of an RF signal (e.g., an RF signal received at first positive input port 435). For instance, the differential pair of first rectification stage 405-a (e.g., transistors 410-a and 410-b) and the differential pair of second rectification stage 405-b (e.g., transistors 410-c and 410-d) may rectify an input (e.g., provided via first negative input port 430, first positive input port 435, second positive input port 440, and second negative input port 445) while the transistors between output port 450 and rectification stages 405-a and 405-b may supply current to rectification stages 405-a and 405-b and may filter the output of rectification stages 405-a and 405-b (e.g., by utilizing resistive element 455 and capacitive element 460).

**In** some examples, a parasitic capacitance of transistor 410-a and a resistive element (e.g., a resistor) coupled with first negative input port 430 may be included in a passive attenuator for first negative input port 430; a parasitic capacitance of transistor 410-b and a resistive element (e.g., a resistor) coupled with first positive input port 435 may be included in a passive attenuator for first positive input port 435; a parasitic capacitance of transistor 410-c and a resistive element (e.g., a resistor) coupled with second positive input port 440 may be included in a passive attenuator for second positive input port 440; and a parasitic capacitance of transistor 410-d and a resistive element (e.g., a resistor) coupled with second negative input port 445 may be included in a passive attenuator for second negative input port 445.

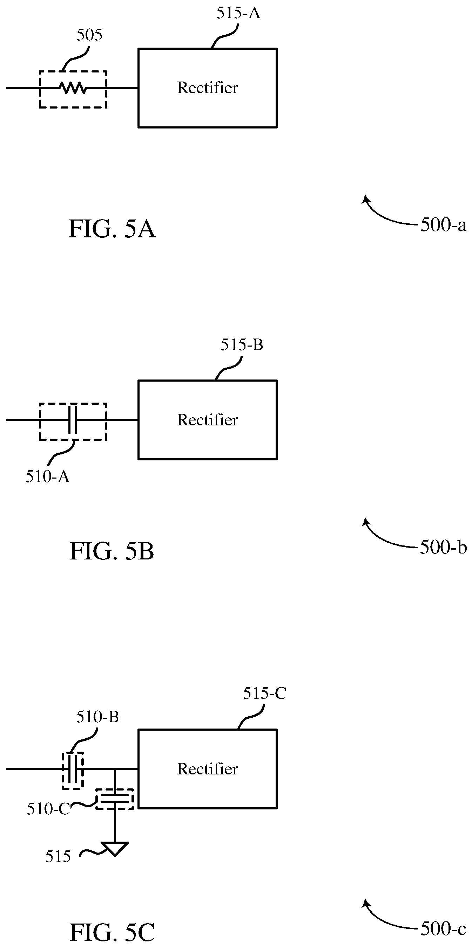

**FIGs. 5A, 5B, and 5C** show examples of passive attenuation schemes 500-a, 500-b, and 500-c that support a wide band power detector with high dynamic range in accordance with aspects of the present disclosure. In some examples, FIGs. 5A, 5B, and 5C may be implemented by one or more aspects of FIGs. 1 and 2. For instance, rectifiers 515-a, 515-b, and 515-c may each be an example of any of rectifiers 115-b or 115-c as described with reference to FIG. 1 or any of rectifiers 215-b through 215-g as described with reference to FIG. 2. Additionally, or alternatively, resistive element 505 (e.g., a resistor) and/or any of capacitive elements 510-a through 510-c (e.g., capacitors) may be examples of components included within any of attenuators 125-a through 125-h as described with reference to FIG. 1 or any attenuator of a set of attenuators 245 of FIG. 2.

FIG. 5A may represent a first passive attenuator that includes a resistive element 505. The resistive element 505, in conjunction with a parasitic capacitance of a transistor of rectifier 515-a, may attenuate an RF signal that is provided to resistive element 505. An output voltage or an output current provided by rectifier 515-a may be dependent on a power of the attenuated RF signal provided to rectifier 515-a via resistive element 505. Although discussed as using the parasitic capacitance of the rectifier 515-a, in some cases a discrete capacitor may be added on the input port of the rectifier 515-a. The value of the resistive element 505 may depend on the desired attenuation, parasitic capacitance of the rectifier 515-a, and frequency range of operation of the power detector.

FIG. 5B may represent a second passive attenuator that includes a capacitive element 510-a (e.g., a capacitor). The capacitive element 510-a may attenuate an RF signal that is provided to the capacitive element 510-a. An output voltage or an output current provided by rectifier 515-b may be dependent on a power of the attenuated RF signal provided to rectifier 515-b via capacitive element 510-a. The value of the capacitive element 510-a may depend on the desired attenuation, parasitic capacitance of the rectifier 515-b, and frequency range of operation of the power detector.

FIG. 5C may represent a third passive attenuator that includes a first capacitive element 510-b (e.g., a capacitor) and a second capacitive element 510-c (e.g., another capacitor). Capacitive element 510-b may be coupled directly with a positive port or a negative port and capacitive element 510-c may be coupled with a signal ground 515. The first capacitive element 510-b and the second capacitive element 510-c may act as a capacitive divider that attenuates an RF signal that is provided to the first capacitive element 510-b. An output voltage or an output current provided by rectifier 515-c may be dependent on a power of the attenuated RF signal provided to rectifier 515-c via first capacitive element 510-b. The value of the capacitive elements 510-b and 510-c may depend on the desired attenuation, parasitic capacitance of the rectifier 515-c, and frequency range of operation of the power detector.

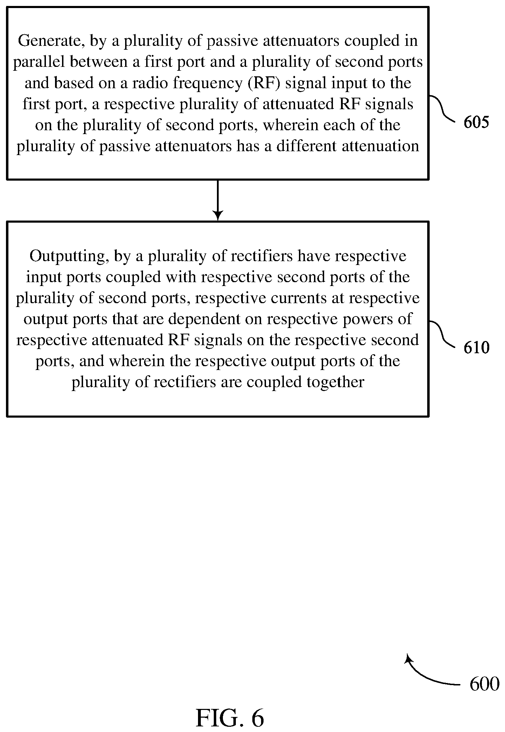

**FIG.** 6 shows a flowchart illustrating a method 600 that supports a wide band power detector with high dynamic range in accordance with aspects of the present disclosure. The operations of the method 600 may be implemented by a device or its components as described herein. For example, the operations of the method 600 may be performed by a device as described with reference to FIGs. 1 through 6. In some examples, a device may execute a set of instructions to control the functional elements of the device to perform the described functions. Additionally, or alternatively, the device may perform aspects of the described functions using special-purpose hardware.

At 605, the method may include generating, by a plurality of passive attenuators coupled in parallel between a first port and a plurality of second ports and based on a radio frequency (RF) signal input to the first port, a respective plurality of attenuated RF signals on the plurality of second ports, wherein each of the plurality of passive attenuators has a different attenuation. The operations of block 605 may be performed in accordance with examples as disclosed herein. In some examples, aspects of the operations of 605 may be performed by an RF signal attenuator 25 as described with reference to FIG..

At 610, the method may include outputting, by a plurality of rectifiers having respective input ports coupled with respective second ports of the plurality of second ports, respective currents at respective output ports that are dependent on respective powers of respective attenuated RF signals on the respective second ports, and wherein the respective output ports of the plurality of rectifiers are coupled together. The operations of block 610 may be performed in accordance with examples as disclosed herein. In some examples, aspects of the operations of 610 may be performed by a voltage output component 30 as described with reference to FIG..

It should be noted that these methods describe examples of implementations, and that the operations and the steps may be rearranged or otherwise modified such that other implementations are possible. In some examples, aspects from two or more of the methods may be combined. For example, aspects of each of the methods may include steps or aspects of the other methods, or other steps or techniques described herein.

Information and signals described herein may be represented using any of a variety of different technologies and techniques. For example, data, instructions, commands, information, signals, bits, symbols, and chips that may be referenced throughout the description may be represented by voltages, currents, electromagnetic waves, magnetic fields or particles, optical fields or particles, or any combination thereof.

The various illustrative blocks and components described in connection with the disclosure herein may be implemented or performed using a general-purpose processor, a DSP, an ASIC, a CPU, an FPGA or other programmable logic device, discrete gate or transistor logic, discrete hardware components, or any combination thereof designed to perform the functions described herein. A general-purpose processor may be a microprocessor but, in the alternative, the processor may be any processor, controller, microcontroller, or state machine. A processor may also be implemented as a combination of computing devices (e.g., a combination of a DSP and a microprocessor, multiple microprocessors, one or more microprocessors in conjunction with a DSP core, or any other such configuration). Any functions or operations described herein as being capable of being performed by a processor may be performed by multiple processors that, individually or collectively, are capable of performing the described functions or operations.

The functions described herein may be implemented in hardware, software executed by a processor, firmware, or any combination thereof. If implemented in software executed by a processor, the functions may be stored on or transmitted over as one or more instructions or code on a computer readable medium. Other examples and implementations are within the scope of the disclosure and appended claims. For example, due to the nature of software, functions described herein can be implemented using software executed by a processor, hardware, firmware, hardwiring, or combinations of any of these. Features implementing functions may also be physically located at various positions, including being distributed such that portions of functions are implemented at different physical locations.

Computer-readable media includes both non-transitory computer storage media and communication media including any medium that facilitates transfer of a computer program from one location to another. A non-transitory storage medium may be any available medium that may be accessed by a general-purpose or special-purpose computer. By way of example, and not limitation, non-transitory computer-readable media may include RAM, ROM, electrically erasable programmable ROM (EEPROM), flash memory, compact disk (CD) ROM or other optical disk storage, magnetic disk storage or other magnetic storage devices, or any other non-transitory medium that may be used to carry or store desired program code means in the form of instructions or data structures and that may be accessed by a general-purpose or special-purpose computer, or a general-purpose or special-purpose processor. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of computer-readable medium. Disk and disc, as used herein, include CD, laser disc, optical disc, digital versatile disc (DVD), floppy disk and Blu-ray disc. Disks may reproduce data magnetically, and discs may reproduce data optically using lasers. Combinations of the above are also included within the scope of computer-readable media. Any functions or operations described herein as being capable of being performed by a memory may be performed by multiple memories that, individually or collectively, are capable of performing the described functions or operations.

As used herein, including in the claims, "or" as used in a list of items (e.g., a list of items prefaced by a phrase such as "at least one of" or "one or more of") indicates an inclusive list such that, for example, a list of at least one of A, B, or C means A or B or C or AB or AC or BC or ABC (i.e., A and B and C). Also, as used herein, the phrase "based on" shall not be construed as a reference to a closed set of conditions. For example, an exemplary step that is described as "based on condition A" may be based on both a condition A and a condition B without departing from the scope of the present disclosure. In other words, as used herein, the phrase "based on" shall be construed in the same manner as the phrase "based at least in part on."

As used herein, including in the claims, the article "a" before a noun is openended and understood to refer to "at least one" of those nouns or "one or more" of those nouns. Thus, the terms "a," "at least one," "one or more," "at least one of one or more" may be interchangeable. For example, if a claim recites "a component" that performs one or more functions, each of the individual functions may be performed by a single component or by any combination of multiple components. Thus, the term "a component" having characteristics or performing functions may refer to "at least one of one or more components" having a particular characteristic or performing a particular function. Subsequent reference to a component introduced with the article "a" using the terms "the" or "said" may refer to any or all of the one or more components. For example, a component introduced with the article "a" may be understood to mean "one or more components," and referring to "the component" subsequently in the claims may be understood to be equivalent to referring to "at least one of the one or more components." Similarly, subsequent reference to a component introduced as "one or more components" using the terms "the" or "said" may refer to any or all of the one or more components. For example, referring to "the one or more components" subsequently in the claims may be understood to be equivalent to referring to "at least one of the one or more components."

In the appended figures, similar components or features may have the same reference label. Further, various components of the same type may be distinguished by following the reference label by a dash and a second label that distinguishes among the similar components. If just the first reference label is used in the specification, the description is applicable to any one of the similar components having the same first reference label irrespective of the second reference label, or other subsequent reference label.

The description set forth herein, in connection with the appended drawings, describes example configurations and does not represent all the examples that may be implemented or that are within the scope of the claims. The term "exemplary" used herein means "serving as an example, instance, or illustration," and not "preferred" or "advantageous over other examples." The detailed description includes specific details for the purpose of providing an understanding of the described techniques. These techniques, however, may be practiced without these specific details. In some instances, well known structures and devices are shown in block diagram form in order to avoid obscuring the concepts of the described examples.

The description herein is provided to enable a person skilled in the art to make or use the disclosure. Various modifications to the disclosure will be readily apparent to those skilled in the art, and the generic principles defined herein may be applied to other variations without departing from the scope of the claims.

## Claims

1. A circuit, comprising:
a plurality of passive attenuators (125-a, 125-e) coupled in parallel between a first port (105-a) and a plurality of second ports (135-a), the plurality of passive attenuators (125-a, 125-e) configured to generate, based on a radio frequency (RF) signal (140-a) input to the first port (105-a), a respective plurality of attenuated RF signals (150) on the plurality of second ports (135-a), wherein each of the plurality of passive attenuators (125-a, 125-e) has a different attenuation;
a plurality of rectifiers (115-b, 115-c) having respective input ports (110-b, 110-c) coupled with respective second ports of the plurality of second ports (135-a), wherein the plurality of rectifiers (115-b, 115-c) are configured to output respective currents (145-b, 145-c) at respective output ports (120-b, 120-c) that are dependent on respective powers (310) of respective attenuated RF signals (150) on the respective second ports (135-a), and wherein the respective output ports (120-b, 120-c) of the plurality of rectifiers (115-b, 115-c) are coupled together, wherein the first port (105-a) is a positive signal port, the plurality of passive attenuators (125-a, 125-e) is a first plurality of passive attenuators, and the input ports (110-b, 110-c) of the plurality of rectifiers (115-b, 115-c) are positive input ports (435); and
a second plurality of passive attenuators (125-c, 125-g) coupled in parallel between a negative signal port (105-b) and a plurality of third ports (135-c), wherein each of the second plurality of passive attenuators (125-c, 125-g) has a different attenuation, and wherein the plurality of rectifiers (115-b, 115-c) has respective negative input ports (430) coupled with respective third ports of the plurality of third ports (135-c).

2. The circuit of claim 1, wherein each of the plurality of rectifiers (115-b, 115-c) comprises a first rectification stage (405-a) between the positive input port (435) and the negative input port (430), and a second rectification stage (405-b) between a second positive input port (440) and a second negative input port (445), the circuit further comprising:
a third plurality of passive attenuators (125-d, 125-h) coupled in parallel between the negative signal port (105-b) and a plurality of fourth ports (135-d), wherein each of the third plurality of passive attenuators (125-d, 125-h) has a different attenuation, and wherein the plurality of rectifiers (115-b, 115-c) has respective second negative input ports (445) coupled with respective fourth ports of the plurality of fourth ports (135-d); and
a fourth plurality of passive attenuators (125-b, 125-f) coupled in parallel between the positive signal port (105-a) and a plurality of fifth ports (135-b), wherein each of the fourth plurality of passive attenuators (125-b, 125-f) has a different attenuation, and wherein the plurality of rectifiers has respective second positive input ports (440) coupled with respective fifth ports of the plurality of fifth ports (135-b).

3. The circuit of claim 2, wherein:
the third plurality of passive attenuators (125-d, 125-h) are configured to generate, based on a second RF signal (140-b) input to the negative signal port (105-b), a respective plurality of attenuated signals on the plurality of fourth ports (135-d) and the fourth plurality of passive attenuators (125-b, 125-f) are configured to generate, based on the RF signal (140-a) input to the positive signal port (105-a), a respective plurality of attenuated signals on the plurality of fifth ports (135-b), and
the respective currents (145-b, 145-c) output by the respective output ports (120-b, 120-c) of the plurality of rectifiers (115-b, 115-c) are further dependent on respective powers (310) of respective attenuated RF signals (150) on the respective fourth ports (135-d) and respective attenuated RF signals (150) of the respective fifth ports (135-b).

4. The circuit of any one of claims 2 or 3, wherein:
each passive attenuator of the third plurality of passive attenuators (125-d, 125-h) has a same attenuation as at least one passive attenuator of the second plurality of passive attenuators (125-c, 125-g), and
each passive attenuator of the fourth plurality of passive attenuators (125-b, 125-f) has a same attenuation as at least one passive attenuator of the first plurality of passive attenuators (125-a, 125-e).

5. The circuit of any one of claims 1 through 4, wherein:
the second plurality of passive attenuators (125-c, 125-g) are configured to generate, based on a second RF signal (140-b) input to the negative signal port (435), a respective plurality of attenuated RF signals (150) on the plurality of third ports (135-c), and
the respective currents (145-b, 145-c) output by the respective output ports (120-b, 120-c) of the plurality of rectifiers (115-b, 115-c) are further dependent on respective powers (310) of respective attenuated RF signals (150) on the respective third ports (135-c),
wherein, optionally, the second RF signal (140-b) is a complementary signal of the RF signal (140-a).

6. The circuit of any one of claims 1 through 5, wherein each passive attenuator of the second plurality of passive attenuators (125-c, 125-g) has a same attenuation as at least one passive attenuator of the first plurality of passive attenuators (125-a, 125-e).

7. The circuit of any one of claims 1 through 6, further comprising:
a rectifier (115-a) separate from the plurality of rectifiers (115-b, 115-c) and that is coupled directly with the first port (105-a), wherein the rectifier (115-a) is configured to output a current (145-a) at an output port (120-a) that is dependent on a power (310) of the RF signal (140-a) input to the first port (105-a), and wherein the output port (120-a) of the rectifier (115-a) is coupled together with the respective output ports (120-b, 120-c) of the plurality of rectifiers (115-b, 115-c).

8. The circuit of any one of claims 1 through 7, wherein the respective current (145-b) for each output port (120-b) of the respective output ports of the plurality of rectifiers (115-b, 115-c) reaches a threshold current (325-a) at a different power value (320-a, 320-b) associated with the RF signal (140-a) relative to the respective currents (145-c) for each other output port (120-c) of the respective output ports of the plurality of rectifiers (115-b, 115-c).

9. The circuit of any one of claims 1 through 8, further comprising:
a plurality of third ports (210), wherein the plurality of rectifiers (115-b, 115-c) are configured to output the respective currents (145-b, 14-c) at the respective output ports (120-b, 120-c) based at least in part on a bias voltage (207) input to the plurality of third ports (135-c), wherein the plurality of rectifiers (115-b, 115-c) has respective input ports (110-b, 110-c) coupled with respective third ports of the plurality of third ports (135-c).

10. The circuit of any one of claims 1 through 9, wherein each passive attenuator of the plurality of passive attenuators (125-a, 125-e) comprises a resistive element (505) or a capacitive element (510-a, 510-b).

11. The circuit of claim 10, wherein the capacitive element (510-b) for each passive attenuator (125-a) comprises a plurality of capacitive elements (510-b, 510-c).

12. The circuit of claim 10, wherein each passive attenuator (125-a) comprises a parasitic capacitance of a respective transistor (410-a) coupled with the resistive element (505) for the passive attenuator (125-a).

13. A method, comprising:
generating, by a plurality of passive attenuators (125-a, 125-e) coupled in parallel between a first port (105-a) and a plurality of second ports (135-a) and based on a radio frequency (RF) signal (140-a) input to the first port (105-a), a respective plurality of attenuated RF signals (150) on the plurality of second ports (135-a), wherein each of the plurality of passive attenuators (125-a, 125-e) has a different attenuation;
outputting, by a plurality of rectifiers (115-b, 115-c) having respective input ports (110-b, 110-c) coupled with respective second ports of the plurality of second ports (125-a, 125-e), respective currents (145-b, 145-c) at respective output ports (120-b, 120-c) that are dependent on respective powers (310) of respective attenuated RF signals (150) on the respective second ports (135-a), and wherein the respective output ports (120-b, 120-c) of the plurality of rectifiers (115-b, 115-c) are coupled together, wherein the first port (105-a) is a positive signal port, the plurality of passive attenuators (125-a, 125-e) is a first plurality of passive attenuators, and the input ports (110-b, 110-c) of the plurality of rectifiers are positive input ports (435); and
generating, by a second plurality of passive attenuators (125-c, 125-g) coupled in parallel between a negative signal port (105-b) and a plurality of third ports (135-c), a respective plurality of attenuated RF signals (150) on the plurality of third ports (135-c), wherein the plurality of rectifiers has respective negative input ports (430) coupled with respective third ports of the plurality of third ports (135-c), wherein each of the second plurality of passive attenuators (125-c, 125-g) has a different attenuation, and wherein outputting the respective currents (145-b, 145-c) by the respective output ports (120-b, 120-c) of the plurality of rectifiers (115-b, 115-c) is further dependent on respective powers (310) of attenuated RF signals (150) on the respective third ports (135-c).

14. The method of claim 13, wherein each of the plurality of rectifiers (115-b, 115-c) comprises a first rectification stage (405-a) between the positive input port (435) and the negative input port (430), and a second rectification stage (405-b) between a second positive input port (440) and a second negative input port (445), the method further comprising:
generating, by a third plurality of passive attenuators (125-d, 125-h) coupled in parallel between the negative signal port (105-b) and a plurality of fourth ports (135-d), a respective plurality of attenuated RF signals (150) on the plurality of fourth ports (135-d), wherein the plurality of rectifiers (115-b, 115-c) has respective second negative input ports (445) coupled with respective fourth ports of the plurality of fourth ports (135-d), wherein each of the third plurality of passive attenuators (125-d, 125-h) has a different attenuation, and wherein outputting the respective currents (145-b, 145-c) by the respective output ports (120-b, 120-c) of the plurality of rectifiers (115-b, 115-c) is further dependent on respective powers (310) of the attenuated RF signals (150) on the respective fourth ports (135-d); and
generating, by a fourth plurality of passive attenuators (125-b, 125-f) coupled in parallel between the positive signal port (105-a) and a plurality of fifth ports (135-b), a respective plurality of attenuated RF signals (150) on the plurality of fifth ports (135-b), wherein the plurality of rectifiers (115-b, 115-c) has respective second positive input ports (440) coupled with respective fifth ports of the plurality of fifth ports (135-b), wherein each of the fourth plurality of passive attenuators (125-b, 125-f) has a different attenuation, and wherein outputting the respective currents (145-b, 145-c) by the respective output ports (120-b, 120-c) of the plurality of rectifiers (115-b, 115-c) is further dependent on respective powers (310) of the attenuated RF signals (150) on the respective fifth ports (135-b).

15. The method of claim 14, wherein:
each passive attenuator of the third plurality of passive attenuators (125-d, 125-h) has a same attenuation as at least one passive attenuator of the second plurality of passive attenuators (125-c, 125-g), and
each passive attenuator of the fourth plurality of passive attenuators (125-b, 125-f) has a same attenuation as at least one passive attenuator of the first plurality of passive attenuators (125-a, 125-e).

## Patentansprüche

1. Schaltung, umfassend:
eine Vielzahl von passiven Dämpfern (125-a, 125-e), die parallel zwischen einem ersten Anschluss (105-a) und einer Vielzahl von zweiten Anschlüssen (135-a) gekoppelt ist, wobei die Vielzahl von passiven Dämpfern (125-a, 125-e) dazu konfiguriert ist, basierend auf einem Hochfrequenz(HF-)Signal (140-a), das in den ersten Anschluss (105-a) eingegeben wird, eine jeweilige Vielzahl von gedämpften HF-Signalen (150) an der Vielzahl von zweiten Anschlüssen (135-a) zu erzeugen, wobei jeder aus der Vielzahl von passiven Dämpfern (125-a, 125-e) eine unterschiedliche Dämpfung aufweist;
eine Vielzahl von Gleichrichtern (115-b, 115-c) mit jeweiligen Eingabeanschlüssen (110-b, 110-c), die mit jeweiligen zweiten Anschlüssen aus der Vielzahl von zweiten Anschlüssen (135-a) gekoppelt sind, wobei die Vielzahl von Gleichrichtern (115-b, 115-c) dazu konfiguriert ist, jeweilige Ströme (145-b, 145-c) an jeweiligen Ausgabeanschlüssen (120-b, 120-c) auszugeben, die von jeweiligen Leistungen (310) von jeweiligen gedämpften HF-Signalen (150) an den jeweiligen zweiten Anschlüssen (135-a) abhängen, und wobei die jeweiligen Ausgabeanschlüsse (120-b, 120-c) aus der Vielzahl von Gleichrichtern (115-b, 115-c) miteinander gekoppelt sind, wobei der erste Anschluss (105-a) ein positiver Signalanschluss ist, die Vielzahl von passiven Dämpfern (125-a, 125-e) eine erste Vielzahl von passiven Dämpfern ist und die Eingabeanschlüsse (110-b, 110-c) der Vielzahl von Gleichrichtern (115-b, 115-c) positive Eingabeanschlüsse (435) sind; und
eine zweite Vielzahl von passiven Dämpfern (125-c, 125-g), die parallel zwischen einem negativen Signalanschluss (105-b) und einer Vielzahl von dritten Anschlüssen (135-c) gekoppelt ist, wobei jeder aus der zweiten Vielzahl von passiven Dämpfern (125-c, 125-g) eine unterschiedliche Dämpfung aufweist und wobei die Vielzahl von Gleichrichtern (115-b, 115-c) jeweilige negative Eingabeanschlüsse (430) aufweist, die mit jeweiligen dritten Anschlüssen aus der Vielzahl von dritten Anschlüssen (135-c) gekoppelt sind.

2. Schaltung nach Anspruch 1, wobei jeder aus der Vielzahl von Gleichrichtern (115-b, 115-c) eine erste Gleichrichterstufe (405-a) zwischen dem positiven Eingabeanschluss (435) und dem negativen Eingabeanschluss (430) und eine zweite Gleichrichterstufe (405-b) zwischen einem zweiten positiven Eingabeanschluss (440) und einem zweiten negativen Eingabeanschluss (445) umfasst, wobei die Schaltung ferner Folgendes umfasst:
eine dritte Vielzahl von passiven Dämpfern (125-d, 125-h), die parallel zwischen dem negativen Signalanschluss (105-b) und einer Vielzahl von vierten Anschlüssen (135-d) gekoppelt ist, wobei jeder aus der dritten Vielzahl von passiven Dämpfern (125-d, 125-h) eine unterschiedliche Dämpfung aufweist und wobei die Vielzahl von Gleichrichtern (115-b, 115-c) jeweilige zweite negative Eingabeanschlüsse (445) aufweist, die mit jeweiligen vierten Anschlüssen aus der Vielzahl von vierten Anschlüssen (135-d) gekoppelt sind; und
eine vierte Vielzahl von passiven Dämpfern (125-b, 125-f), die parallel zwischen dem positiven Signalanschluss (105-a) und einer Vielzahl von fünften Anschlüssen (135-b) gekoppelt ist, wobei jeder aus der vierten Vielzahl von passiven Dämpfern (125-b, 125-f) eine unterschiedliche Dämpfung aufweist und wobei die Vielzahl von Gleichrichtern jeweilige zweite positive Eingabeanschlüsse (440) aufweist, die mit jeweiligen fünften Anschlüssen aus der Vielzahl von fünften Anschlüssen (135-b) gekoppelt sind.

3. Schaltung nach Anspruch 2, wobei:
die dritte Vielzahl von passiven Dämpfern (125-d, 125-h) dazu konfiguriert ist, basierend auf einem zweiten HF-Signal (140-b), das in den negativen Signalanschluss (105-b) eingegeben wird, eine jeweilige Vielzahl von gedämpften Signalen an der Vielzahl von vierten Anschlüssen (135-d) zu erzeugen und die vierte Vielzahl von passiven Dämpfern (125-b, 125-f) dazu konfiguriert ist, basierend auf dem HF-Signal (140-a), das in den positiven Signalanschluss (105-a) eingegeben wird, eine jeweilige Vielzahl von gedämpften Signalen an der Vielzahl von fünften Anschlüssen (135-b) zu erzeugen, und
die jeweiligen Ströme (145-b, 145-c), die durch die jeweiligen Ausgabeanschlüsse (120-b, 120-c) der Vielzahl von Gleichrichtern (115-b, 115-c) ausgegeben werden, ferner von jeweiligen Leistungen (310) von jeweiligen gedämpften HF-Signalen (150) an den jeweiligen vierten Anschlüssen (135-d) und jeweiligen gedämpften HF-Signalen (150) der jeweiligen fünften Anschlüsse (135-b) abhängen.

4. Schaltung nach einem der Ansprüche 2 oder 3, wobei:
jeder passive Dämpfer aus der dritten Vielzahl von passiven Dämpfern (125-d, 125-h) eine gleiche Dämpfung wie zumindest ein passiver Dämpfer aus der zweiten Vielzahl von passiven Dämpfern (125-c, 125-g) aufweist, und
jeder passive Dämpfer aus der vierten Vielzahl von passiven Dämpfern (125-b, 125-f) eine gleiche Dämpfung wie zumindest ein passiver Dämpfer aus der ersten Vielzahl von passiven Dämpfern (125-a, 125-e) aufweist.

5. Schaltung nach einem der Ansprüche 1 bis 4, wobei:
die zweite Vielzahl von passiven Dämpfern (125-c, 125-g) dazu konfiguriert ist, basierend auf einem zweiten HF-Signal (140-b), das in den negativen Signalanschluss (435) eingegeben wird, eine jeweilige Vielzahl von gedämpften HF-Signalen (150) an der Vielzahl von dritten Anschlüssen (135-c) zu erzeugen, und
die jeweiligen Ströme (145-b, 145-c), die durch die jeweiligen Ausgabeanschlüsse (120-b, 120-c) der Vielzahl von Gleichrichtern (115-b, 115-c) ausgegeben werden, ferner von jeweiligen Leistungen (310) von jeweiligen gedämpften HF-Signalen (150) an den jeweiligen dritten Anschlüssen (135-c) abhängen,
wobei optional das zweite HF-Signal (140-b) ein komplementäres Signal des HF-Signals (140-a) ist.

6. Schaltung nach einem der Ansprüche 1 bis 5, wobei jeder passive Dämpfer aus der zweiten Vielzahl von passiven Dämpfern (125-c, 125-g) eine gleiche Dämpfung wie zumindest ein passiver Dämpfer aus der ersten Vielzahl von passiven Dämpfern (125-a, 125-e) aufweist.

7. Schaltung nach einem der Ansprüche 1 bis 6, ferner umfassend:
einen Gleichrichter (115-a) separat von der Vielzahl von Gleichrichtern (115-b, 115-c) und der direkt mit dem ersten Anschluss (105-a) gekoppelt ist, wobei der Gleichrichter (115-a) dazu konfiguriert ist, einen Strom (145-a) an einem Ausgabeanschluss (120-a) auszugeben, der von einer Leistung (310) des HF-Signals (140-a) abhängt, das in den ersten Anschluss (105-a) eingegeben wird, und wobei der Ausgabeanschluss (120-a) des Gleichrichters (115-a) zusammen mit den jeweiligen Ausgabeanschlüssen (120-b, 120-c) der Vielzahl von Gleichrichtern (115-b, 115-c) gekoppelt ist.

8. Schaltung nach einem der Ansprüche 1 bis 7, wobei der jeweilige Strom (145-b) für jeden Ausgabeanschluss (120-b) der jeweiligen Ausgabeanschlüsse der Vielzahl von Gleichrichtern (115-b, 115-c) einen Schwellenstrom (325-a) bei einem unterschiedlichen Leistungswert (320-a, 320-b) assoziiert mit dem HF-Signal (140-a) relativ zu den jeweiligen Strömen (145-c) für jeden anderen Ausgabeanschluss (120-c) der jeweiligen Ausgabeanschlüsse der Vielzahl von Gleichrichtern (115-b, 115-c) erreicht.

9. Schaltung nach einem der Ansprüche 1 bis 8, ferner umfassend:
eine Vielzahl von dritten Anschlüssen (210), wobei die Vielzahl von Gleichrichtern (115-b, 115-c) dazu konfiguriert ist, die jeweiligen Ströme (145-b, 14-c) an den jeweiligen Ausgabeanschlüssen (120-b, 120-c) basierend zumindest teilweise auf einer Vorspannung (207) auszugeben, die in die Vielzahl von dritten Anschlüssen (135-c) eingegeben wird, wobei die Vielzahl von Gleichrichtern (115-b, 115-c) jeweilige Eingabeanschlüsse (110-b, 110-c) aufweist, die mit jeweiligen dritten Anschlüssen aus der Vielzahl von dritten Anschlüssen (135-c) gekoppelt sind.

10. Schaltung nach einem der Ansprüche 1 bis 9, wobei jeder passive Dämpfer aus der Vielzahl von passiven Dämpfern (125-a, 125-e) ein Widerstandselement (505) oder ein kapazitives Element (510-a, 510-b) umfasst.

11. Schaltung nach Anspruch 10, wobei das kapazitive Element (510-b) für jeden passiven Dämpfer (125-a) eine Vielzahl von kapazitiven Elementen (510-b, 510-c) umfasst.

12. Schaltung nach Anspruch 10, wobei jeder passive Dämpfer (125-a) eine parasitäre Kapazität eines jeweiligen Transistors (410-a) umfasst, der mit dem Widerstandselement (505) für den passiven Dämpfer (125-a) gekoppelt ist.

13. Verfahren, umfassend:
Erzeugen, durch eine Vielzahl von passiven Dämpfern (125-a, 125-e), die parallel zwischen einem ersten Anschluss (105-a) und einer Vielzahl von zweiten Anschlüssen (135-a) gekoppelt ist, und basierend auf einem Funkfrequenz(HF-)Signal (140-a), das in den ersten Anschluss (105-a) eingegeben wird, einer jeweiligen Vielzahl von gedämpften HF-Signalen (150) an der Vielzahl von zweiten Anschlüssen (135-a), wobei jeder aus der Vielzahl von passiven Dämpfern (125-a, 125-e) eine unterschiedliche Dämpfung aufweist;
Ausgeben, durch eine Vielzahl von Gleichrichtern (115-b, 115-c) mit jeweiligen Eingabeanschlüssen (110-b, 110-c), die mit jeweiligen zweiten Anschlüssen aus der Vielzahl von zweiten Anschlüssen (125-a, 125-e) gekoppelt sind, von jeweiligen Strömen (145-b, 145-c) an jeweiligen Ausgabeanschlüssen (120-b, 120-c), die von jeweiligen Leistungen (310) von jeweiligen gedämpften HF-Signalen (150) an den jeweiligen zweiten Anschlüssen (135-a) abhängen, und wobei die jeweiligen Ausgabeanschlüsse (120-b, 120-c) der Vielzahl von Gleichrichtern (115-b, 115-c) miteinander gekoppelt sind, wobei der erste Anschluss (105-a) ein positiver Signalanschluss ist, die Vielzahl von passiven Dämpfern (125-a, 125-e) eine erste Vielzahl von passiven Dämpfern ist und die Eingabeanschlüsse (110-b, 110-c) aus der Vielzahl von Gleichrichtern positive Eingabeanschlüsse (435) sind; und
Erzeugen, durch eine zweite Vielzahl von passiven Dämpfern (125-c, 125-g), die parallel zwischen einem negativen Signalanschluss (105-b) und einer Vielzahl von dritten Anschlüssen (135-c) gekoppelt ist, einer jeweiligen Vielzahl von gedämpften HF-Signalen (150) an der Vielzahl von dritten Anschlüssen (135-c), wobei die Vielzahl von Gleichrichtern jeweilige negative Eingabeanschlüsse (430) aufweist, die mit jeweiligen dritten Anschlüssen aus der Vielzahl von dritten Anschlüssen (135-c) gekoppelt sind, wobei jeder aus der zweiten Vielzahl von passiven Dämpfern (125-c, 125-g) eine unterschiedliche Dämpfung aufweist und wobei das Ausgeben der jeweiligen Ströme (145-b, 145-c) durch die jeweiligen Ausgabeanschlüsse (120-b, 120-c) der Vielzahl von Gleichrichtern (115-b, 115-c) ferner von jeweiligen Leistungen (310) von gedämpften HF-Signalen (150) an den jeweiligen dritten Anschlüssen (135-c) abhängt.

14. Verfahren nach Anspruch 13, wobei jeder aus der Vielzahl von Gleichrichtern (115-b, 115-c) eine erste Gleichrichterstufe (405-a) zwischen dem positiven Eingabeanschluss (435) und dem negativen Eingabeanschluss (430) und eine zweite Gleichrichterstufe (405-b) zwischen einem zweiten positiven Eingabeanschluss (440) und einem zweiten negativen Eingabeanschluss (445) umfasst, wobei das Verfahren ferner Folgendes umfasst:
Erzeugen, durch eine dritte Vielzahl von passiven Dämpfern (125-d, 125-h), die parallel zwischen dem negativen Signalanschluss (105-b) und einer Vielzahl von vierten Anschlüssen (135-d) gekoppelt ist, einer jeweiligen Vielzahl von gedämpften HF-Signalen (150) an der Vielzahl von vierten Anschlüssen (135-d), wobei die Vielzahl von Gleichrichtern (115-b, 115-c) jeweilige zweite negative Eingabeanschlüsse (445) aufweist, die mit jeweiligen vierten Anschlüssen aus der Vielzahl von vierten Anschlüssen (135-d) gekoppelt sind, wobei jeder aus der dritten Vielzahl von passiven Dämpfern (125-d, 125-h) eine unterschiedliche Dämpfung aufweist, und wobei das Ausgeben der jeweiligen Ströme (145-b, 145-c) durch die jeweiligen Ausgabeanschlüsse (120-b, 120-c) der Vielzahl von Gleichrichtern (115-b, 115-c) ferner von jeweiligen Leistungen (310) der gedämpften HF-Signale (150) an den jeweiligen vierten Anschlüssen (135-d) abhängt; und
Erzeugen, durch eine vierte Vielzahl von passiven Dämpfern (125-b, 125-f), die parallel zwischen dem positiven Signalanschluss (105-a) und einer Vielzahl von fünften Anschlüssen (135-b) gekoppelt ist, einer jeweiligen Vielzahl von gedämpften HF-Signalen (150) an der Vielzahl von fünften Anschlüssen (135-b), wobei die Vielzahl von Gleichrichtern (115-b, 115-c) jeweilige zweite positive Eingabeanschlüsse (440) aufweist, die mit jeweiligen fünften Anschlüssen aus der Vielzahl von fünften Anschlüssen (135-b) gekoppelt sind, wobei jeder aus der vierten Vielzahl von passiven Dämpfern (125-b, 125-f) eine unterschiedliche Dämpfung aufweist und wobei das Ausgeben der jeweiligen Ströme (145-b, 145-c) durch die jeweiligen Ausgabeanschlüsse (120-b, 120-c) der Vielzahl von Gleichrichtern (115-b, 115-c) ferner von jeweiligen Leistungen (310) der gedämpften HF-Signale (150) an den jeweiligen fünften Anschlüssen (135-b) abhängt.

15. Verfahren nach Anspruch 14, wobei:
jeder passive Dämpfer aus der dritten Vielzahl von passiven Dämpfern (125-d, 125-h) eine gleiche Dämpfung wie zumindest ein passiver Dämpfer aus der zweiten Vielzahl von passiven Dämpfern (125-c, 125-g) aufweist, und
jeder passive Dämpfer aus der vierten Vielzahl von passiven Dämpfern (125-b, 125-f) eine gleiche Dämpfung wie zumindest ein passiver Dämpfer aus der ersten Vielzahl von passiven Dämpfern (125-a, 125-e) aufweist.

## Revendications

1. Circuit, comprenant :
une pluralité d'atténuateurs passifs (125-a, 125-e) couplés en parallèle entre un premier port (105-a) et une pluralité de deuxièmes ports (135-a), la pluralité d'atténuateurs passifs (125-a, 125-e) étant configurés pour générer, sur la base d'un signal radiofréquence (RF) (140-a) entré dans le premier port (105-a), une pluralité respective de signaux RF atténués (150) sur la pluralité de deuxièmes ports (135-a), dans lequel chacun de la pluralité d'atténuateurs passifs (125-a, 125-e) a une atténuation différente ;
une pluralité de redresseurs (115-b, 115-c) ayant des ports d'entrée respectifs (110-b, 110-c) couplés à des deuxièmes ports respectifs de la pluralité de deuxièmes ports (135-a), dans lequel la pluralité de redresseurs (115-b, 115-c) sont configurés pour sortir des courants respectifs (145-b, 145-c) au niveau de ports de sortie respectifs (120-b, 120-c) qui dépendent des puissances respectives (310) des signaux RF atténués respectifs (150) sur les deuxièmes ports respectifs (135-a), et dans lequel les ports de sortie respectifs (120-b, 120-c) de la pluralité de redresseurs (115-b, 115-c) sont couplés ensemble, dans lequel le premier port (105-a) est un port de signal positif, la pluralité d'atténuateurs passifs (125-a, 125-e) sont une première pluralité d'atténuateurs passifs, et les ports d'entrée (110-b, 110-c) de la pluralité de redresseurs (115-b, 115-c) sont des ports d'entrée positifs (435) ; et
une deuxième pluralité d'atténuateurs passifs (125-c, 125-g) couplés en parallèle entre un port de signal négatif (105-b) et une pluralité de troisièmes ports (135-c), dans lequel chacun de la deuxième pluralité d'atténuateurs passifs (125-c, 125-g) a une atténuation différente, et dans lequel la pluralité de redresseurs (115-b, 115-c) ont des ports d'entrée négatifs respectifs (430) couplés à des troisièmes ports respectifs de la pluralité de troisièmes ports (135-c).

2. Circuit selon la revendication 1, dans lequel chacun de la pluralité de redresseurs (115-b, 115-c) comprend un premier étage de redressement (405-a) entre le port d'entrée positif (435) et le port d'entrée négatif (430), et un deuxième étage de redressement (405-b) entre un deuxième port d'entrée positif (440) et un deuxième port d'entrée négatif (445), le circuit comprenant en outre :
une troisième pluralité d'atténuateurs passifs (125-d, 125-h) couplés en parallèle entre le port de signal négatif (105-b) et une pluralité de quatrièmes ports (135-d), dans lequel chacun de la troisième pluralité d'atténuateurs passifs (125-d, 125-h) a une atténuation différente, et dans lequel la pluralité de redresseurs (115-b, 115-c) ont des deuxièmes ports d'entrée négatifs respectifs (445) couplés à des quatrièmes ports respectifs de la pluralité de quatrièmes ports (135-d) ; et
une quatrième pluralité d'atténuateurs passifs (125-b, 125-f) couplés en parallèle entre le port de signal positif (105-a) et une pluralité de cinquièmes ports (135-b), dans lequel chacun de la quatrième pluralité d'atténuateurs passifs (125-b, 125-f) a une atténuation différente, et dans lequel la pluralité de redresseurs ont des deuxièmes ports d'entrée positifs respectifs (440) couplés à des cinquièmes ports respectifs de la pluralité de cinquièmes ports (135-b).

3. Circuit selon la revendication 2, dans lequel :
la troisième pluralité d'atténuateurs passifs (125-d, 125-h) sont configurés pour générer, sur la base d'un deuxième signal RF (140-b) entré dans le port de signal négatif (105-b), une pluralité respective de signaux atténués sur la pluralité de quatrièmes ports (135-d) et la quatrième pluralité d'atténuateurs passifs (125-b, 125-f) sont configurés pour générer, sur la base du signal RF (140-a) entré dans le port de signal positif (105-a), une pluralité respective de signaux atténués sur la pluralité de cinquièmes ports (135-b), et
les courants respectifs (145-b, 145-c) sortis par les ports de sortie respectifs (120-b, 120-c) de la pluralité de redresseurs (115-b, 115-c) dépendent en outre des puissances respectives (310) des signaux RF atténués respectifs (150) sur les quatrièmes ports respectifs (135-d) et des signaux RF atténués respectifs (150) des cinquièmes ports respectifs (135-b).

4. Circuit selon l'une quelconque des revendications 2 ou 3, dans lequel :
chaque atténuateur passif de la troisième pluralité d'atténuateurs passifs (125-d, 125-h) a une même atténuation qu'au moins un atténuateur passif de la deuxième pluralité d'atténuateurs passifs (125-c, 125-g), et
chaque atténuateur passif de la quatrième pluralité d'atténuateurs passifs (125-b, 125-f) a une même atténuation qu'au moins un atténuateur passif de la première pluralité d'atténuateurs passifs (125-a, 125-e).

5. Circuit selon l'une quelconque des revendications 1 à 4, dans lequel :
la deuxième pluralité d'atténuateurs passifs (125-c, 125-g) sont configurés pour générer, sur la base d'un deuxième signal RF (140-b) entré dans le port de signal négatif (435),
une pluralité respective de signaux RF atténués (150) sur la pluralité de troisièmes ports (135-c), et
les courants respectifs (145-b, 145-c) sortis par les ports de sortie respectifs (120-b, 120-c) de la pluralité de redresseurs (115-b, 115-c) dépendent en outre des puissances respectives (310) des signaux RF atténués respectifs (150) sur les troisièmes ports respectifs (135-c),
dans lequel, facultativement, le deuxième signal RF (140-b) est un signal complémentaire du signal RF (140-a).

6. Circuit selon l'une quelconque des revendications 1 à 5, dans lequel chaque atténuateur passif de la deuxième pluralité d'atténuateurs passifs (125-c, 125-g) a une même atténuation qu'au moins un atténuateur passif de la première pluralité d'atténuateurs passifs (125-a, 125-e).

7. Circuit selon l'une quelconque des revendications 1 à 6, comprenant en outre :
un redresseur (115-a) séparé de la pluralité de redresseurs (115-b, 115-c) et qui est couplé directement au premier port (105-a), dans lequel le redresseur (115-a) est configuré pour sortir un courant (145-a) au niveau d'un port de sortie (120-a) qui dépend d'une puissance (310) du signal RF (140-a) entré dans le premier port (105-a), et dans lequel le port de sortie (120-a) du redresseur (115-a) est couplé conjointement aux ports de sortie respectifs (120-b, 120-c) de la pluralité de redresseurs (115-b, 115-c).

8. Circuit selon l'une quelconque des revendications 1 à 7, dans lequel le courant respectif (145-b) pour chaque port de sortie (120-b) des ports de sortie respectifs de la pluralité de redresseurs (115-b, 115-c) atteint un courant de seuil (325-a) à une valeur de puissance différente (320-a, 320-b) associée au signal RF (140-a) par rapport aux courants respectifs (145-c) pour chaque autre port de sortie (120-c) des ports de sortie respectifs de la pluralité de redresseurs (115-b, 115-c).

9. Circuit selon l'une quelconque des revendications 1 à 8, comprenant en outre :
une pluralité de troisièmes ports (210), dans lequel la pluralité de redresseurs (115-b, 115-c) sont configurés pour sortir les courants respectifs (145-b, 14-c) au niveau des ports de sortie respectifs (120-b, 120-c) sur la base au moins en partie d'une tension de polarisation (207) entrée dans la pluralité de troisièmes ports (135-c), dans lequel la pluralité de redresseurs (115-b, 115-c) a
des ports d'entrée respectifs (110-b, 110-c) couplés à des troisièmes ports respectifs de la pluralité de troisièmes ports (135-c).

10. Circuit selon l'une quelconque des revendications 1 à 9, dans lequel chaque atténuateur passif de la pluralité d'atténuateurs passifs (125-a, 125-e) comprend un élément résistif (505) ou un élément capacitif (510-a, 510-b).

11. Circuit selon la revendication 10, dans lequel l'élément capacitif (510-b) pour chaque atténuateur passif (125-a) comprend une pluralité d'éléments capacitifs (510-b, 510-c).

12. Circuit selon la revendication 10, dans lequel chaque atténuateur passif (125-a) comprend une capacité parasite d'un transistor respectif (410-a) couplé à l'élément résistif (505) pour l'atténuateur passif (125-a).

13. Procédé, comprenant :
la génération, par une pluralité d'atténuateurs passifs (125-a, 125-e) couplés en parallèle entre un premier port (105-a) et une pluralité de deuxièmes ports (135-a) et sur la base d'un signal radiofréquence (RF) (140-a) entré dans le premier port (105-a), d'une pluralité respective de signaux RF atténués (150) sur la pluralité de deuxièmes ports (135-a), dans lequel chacun de la pluralité d'atténuateurs passifs (125-a, 125-e) a une atténuation différente ;
la sortie, par une pluralité de redresseurs (115-b, 115-c) ayant des ports d'entrée respectifs (110-b, 110-c) couplés à des deuxièmes ports respectifs de la pluralité de deuxièmes ports (125-a, 125-e), de courants respectifs (145-b, 145-c) au niveau des ports de sortie respectifs (120-b, 120-c) qui dépendent des puissances respectives (310) des signaux RF atténués respectifs (150) sur les deuxièmes ports respectifs (135-a), et dans lequel les ports de sortie respectifs (120-b, 120-c) de la pluralité de redresseurs (115-b, 115-c) sont couplés ensemble, dans lequel le premier port (105-a) est un port de signal positif, la pluralité d'atténuateurs passifs (125-a, 125-e) sont une première pluralité d'atténuateurs passifs, et les ports d'entrée (110-b, 110-c) de la pluralité de redresseurs sont des ports d'entrée positifs (435) ; et
la génération, par une deuxième pluralité d'atténuateurs passifs (125-c, 125-g) couplés en parallèle entre un port de signal négatif (105-b) et une pluralité de troisièmes ports (135-c), d'une pluralité respective de signaux RF atténués (150) sur la pluralité de troisièmes ports (135-c), dans lequel la pluralité de redresseurs ont des ports d'entrée négatifs respectifs (430) couplés à des troisièmes ports respectifs de la pluralité de troisièmes ports (135-c), dans lequel chacun
de la deuxième pluralité d'atténuateurs passifs (125-c, 125-g) a une atténuation différente, et dans lequel la sortie des courants respectifs (145-b, 145-c) par les ports de sortie respectifs (120-b, 120-c) de la pluralité de redresseurs (115-b, 115-c) dépend en outre des puissances respectives (310) des signaux RF atténués (150) sur les troisièmes ports respectifs (135-c).

14. Procédé selon la revendication 13, dans lequel chacun de la pluralité de redresseurs (115-b, 115-c) comprend un premier étage de redressement (405-a) entre le port d'entrée positif (435) et le port d'entrée négatif (430), et un deuxième étage de redressement (405-b) entre un deuxième port d'entrée positif (440) et un deuxième port d'entrée négatif (445), le procédé comprenant en outre :
la génération, par une troisième pluralité d'atténuateurs passifs (125-d, 125-h) couplés en parallèle entre le port de signal négatif (105-b) et une pluralité de quatrièmes ports (135-d), d'une pluralité respective de signaux RF atténués (150) sur la pluralité de quatrièmes ports (135-d), dans lequel la pluralité de redresseurs (115-b, 115-c) a des deuxièmes ports d'entrée négatifs respectifs (445) couplés à des quatrièmes ports respectifs de la pluralité de quatrièmes ports (135-d), dans lequel chacun de la troisième pluralité d'atténuateurs passifs (125-d, 125-h) a une atténuation différente, et dans lequel la sortie des courants respectifs (145-b, 145-c) par les ports de sortie respectifs (120-b, 120-c) de la pluralité de redresseurs (115-b, 115-c) dépend en outre des puissances respectives (310) des signaux RF atténués (150) sur les quatrièmes ports respectifs (135-d) ; et
la génération, par une quatrième pluralité d'atténuateurs passifs (125-b, 125-f) couplés en parallèle entre le port de signal positif (105-a) et une pluralité de cinquièmes ports (135-b), d'une pluralité respective de signaux RF atténués (150) sur la pluralité de cinquièmes ports (135-b), dans lequel la pluralité de redresseurs (115-b, 115-c) ont des deuxièmes ports d'entrée positifs respectifs (440) couplés à des cinquièmes ports respectifs de la pluralité de cinquièmes ports (135-b), dans lequel chacun de la quatrième pluralité d'atténuateurs passifs (125-b, 125-f) a une atténuation différente, et dans lequel la sortie des courants respectifs (145-b, 145-c) par les ports de sortie respectifs (120-b, 120-c) de la pluralité de redresseurs (115-b, 115-c) dépend en outre des puissances respectives (310) des signaux RF atténués (150) sur les cinquièmes ports respectifs (135-b).

15. Procédé selon la revendication 14, dans lequel :
chaque atténuateur passif de la troisième pluralité d'atténuateurs passifs (125-d, 125-h) a une même atténuation qu'au moins un atténuateur passif de la deuxième pluralité d'atténuateurs passifs (125-c, 125-g), et
chaque atténuateur passif de la quatrième pluralité d'atténuateurs passifs (125-b, 125-f) a une même atténuation qu'au moins un atténuateur passif de la première pluralité d'atténuateurs passifs (125-a, 125-e).
